Europäisches Patentamt

European Patent Office

Office européen des brevets

(11) Publication number: **0 223 881**
A1

## EUROPEAN PATENT APPLICATION

(21) Application number: **85201907.4**

(22) Date of filing: **19.11.85**

(51) Int. Cl.⁴ **B41N 3/08** , G03F 7/06

(43) Date of publication of application:
**03.06.87 Bulletin 87/23**

(84) Designated Contracting States:
**AT BE CH DE FR GB IT LI LU NL SE**

(71) Applicant: **AGFA-GEVAERT naamloze vennootschap**
**Septestraat 27**
**B-2510 Mortsel(BE)**

(72) Inventor: **Heugebaert, Frans Clement**
**Pronkenbergstraat 10**
**B-2550 Kontich(BE)**

(54) Lithographic printing with the aid of a fountain liquid.

(57) Method for lithographic printing by means of a lithographic printing plate, which has been prepared from a photolithographic sheet element according to the silver complex diffusion transfer reversal process and carries an oleophilic silver image on its surface, said method comprising moistening said lithographic printing plate with a fountain liquid, supplying ink to the moistened printing plate, and printing, characterized in that said fountain liquid comprises triacetin in an amount of about 0.1 to about 30 percent by volume.

The present invention also provides a fountain liquid that comprises triacetin in an amount of about 0.1 to about 30 percent by volume.

EP 0 223 881 A1

# LITHOGRAPHIC PRINTING WITH THE AID OF A FOUNTAIN LIQUID

The present invention relates to a method of treating a lithographic printing plate with a fountain liquid that comprises triacetin as well as to such fountain liquid comprising triacetin .

In general, planographic or lithographic printing plates are made through photographic imaging means. Photolithographic printing plates can be made by a photographic process using silver halide. It is commonly known to use silver images produced according to the silver complex diffusion transfer reversal process (DTR-process) as printing plates. For instance GB-A 1,241,661 describes a process of making a planographic printing plate by the use of a sheet material comprising an outer hydrophilic colloid layer on the surface of which there is concentrated a silver image that has been formed on said surface from complexed silver halide by the DTR-process.

During the printing operation such printing plates, which carry a line or dot image, need to be moistened with a fountain liquid so as to wet the non-image areas of the printing plates and consequently prevent printing ink from depositing in these non-image areas. A deposit of ink in the non-image areas, however slight it may be, impairs the print quality. To avoid such fog or tinting in the print and thus to obtain better control of the ink and water feed on the printing plates, additives have been used in fountain liquids. For instance alcohols, especially isopropanol were used in amounts of up to 30 °⁰ by volume. However, during transport of the fountain liquid by rollers of the lithographic press the volatile alcohols evaporate. Moreover, isopropanol, which has been the most frequently used alcohol, happens to be toxic, flammable, and relatively expensive.

US-A 3,877,372 describes an attempt to eliminate isopropanol from the fountain solution and use a mixture of butyl cellosolve, a silicone glycol copolymer, and a defoamer.

A commercially available fountain liquid comprises 3-hydroxymethyl-4-heptanol as a substitute for isopropanol.

In EP-A 0,066,176 a fountain solution is described, which contains a mixture of a polyol and/or glycol ether partially soluble in water and a polyol and or glycol ether completely soluble in water.

Other attempts were made to find replacements for isopropanol. However, it was found that in many cases minute ink droplets deposit in the non-image areas. In the case of dot images this may even lead to the merging of the dots so that unsharp prints are obtained.

Attempts are therefore still being made to eliminate these disadvantages and to improve the control of the ink and water feed.

In accordance with the present invention a method has been found for lithographic printing by means of a lithographic printing plate, which has been prepared from a photolithographic sheet element according to the silver complex diffusion transfer reversal process and carries an oleophilic silver image on its surface, said method comprising moistening said lithographic printing plate with a fountain liquid, supplying ink to the moistened printing plate, and printing, characterized in that said fountain liquid comprises triacetin in an amount of about 0.1 to about 30 percent by volume.

The present invention also provides a fountain liquid that comprises triacetin in an amount of about 0.1 to about 30 percent by volume.

According to a preferred embodiment the fountain liquid for use in accordance with the present invention comprises from about 0.8 to about 5 percent by volume of triacetin.

The fountain liquid for use in accordance with the present invention is an aqueous acidic solution. For acidifying the liquid, preference is given to phosphoric acid and/or acid phosphate salts e.g. primary and secondary sodium or ammonium phosphate. Other inorganic acids such as nitric acid and hydrochloric acid or organic acids such as acetic acid and citric acid can be used as well.

Other ingredients such as polyols and or glycol ethers, which have to be completely soluble in water e.g. 1,2-propanediol, diethylene glycol, di-isopropylene glycol, 2,3-hexanediol, and polyethylene glycol (average molecular weight: e.g. 400) can be present in the fountain liquid to improve the control of the ink and water feed. In consequence of the additional presence of such polyols and/or glycol ethers in the fountain liquid the range between the minimum feed volume and the maximum feed volume of said fountain liquid giving good printing quality is widened so that the adjustment of the dampening system is less critical and needs less control. Moreover, the volume of fountain liquid to be supplied to the printing plate so as to achieve good printing quality is lower than with fountain liquid comprising no such polyols and or glycol ethers.

It may also be desirable to incorporate known additives such as e.g. hydrophilic colloid binders, buffering agents, preservatives, corrosion inhibitors, and hardeners into the fountain liquid. Such additives can be used in amounts of from about 0.01 to about 5 percent by volume.

For details about the making of photolithographic printing plates according to the DTR-process as well as about the composition of photographic materials used therefor, reference can be made to the above-mentioned GB-A 1,241,661.

The following examples illustrate the present invention.

EXAMPLE 1

Several SUPERMASTER (trade mark of AGFA-GEVAERT Belgium) photolithographic elements were exposed and processed in an identical way to form printing plates carrying a dot image. The printing procedure with each of the resulting printing plates was as follows.

A dry printing plate was placed on a lithographic press, e.g. an AB DICK-350 offset printing press with a recirculating dampening system comprising a fountain liquid as specified hereinafter. The ink used was VANSON RUBBERBASE 2329 commercially available ink.

The press was run with the damper comprising a fountain liquid F having the following composition:

primary sodium phosphate dihydrate          6 g
secondary sodium phosphate dodecahydrate   1 g
1,2-propanediol                                         50 ml
water to make                                         1000 ml

With the damper set at speeds 20 or 15 running approximately 200 sheets of paper at each setting, the prints obtained showed heavy fog.

For further comparison the press was run with the damper comprising a fountain liquid F, to which the compound corresponding to the formula:

$HOCH_2C(CH_3)_2CH_2OCOC(CH_3)_2CH_2OH$

had been added in an amount of 2 percent by volume.

With the damper set at speeds 20 or 15 running approximately 200 sheets of paper at each setting, the prints obtained still showed substantial fog.

When instead of the above-mentioned diol compound triacetin was added to the fountain liquid F in an amount of 0.01 percent by volume, the prints obtained still showed substantial fog.

When triacetin was added to the fountain liquid F in an amount of 0.3 percent by volume, the prints obtained were substantially free of fog and had good quality.

When, however, triacetin was added to the fountain liquid F in an amount of 2 percent by volume, the prints obtained with the damper set at speed 15 were completely free of fog and no merging of the dots (95 % at 48 lines per cm) could be observed at all, thus yielding an excellent print quality.

EXAMPLE 2

Several printing plates were prepared identically as described in Example 1. The printing procedure with each of the resulting printing plates was as follows.

The dry printing plate was placed on a HEIDELBERG T-Offset (TOK) press and moistened with a fountain liquid as specified hereinafter. The ink used was a commercially available KAST + EHINGER 4F 347 blue ink.

When the fountain liquid having the following composition was used:

primary sodium phosphate dihydrate          6 g
secondary sodium phosphate dodecahydrate   1 g
triacetin                                              20 ml
water to make                                         1000 ml

the prints obtained with the damper set at position 1 were substantially free of fog and showed good quality.

When to the latter fountain liquid a volume of 50 ml of diethylene glycol, di-isopropylene glycol, 2,3-hexanediol, or polyethylene glycol (average molecular weight: 400) was added, the prints obtained with the damper set at position 1 were entirely free of fog and showed an excellent quality to improve the control of the ink and water feed. In consequence of the additional presence of these polyols or glycol ethers the range between the minimum feed volume and the maximum feed volume giving good printing quality was widened so that the adjustment of the dampening system was less critical and needed less control. Moreover, the volume of fountain liquid to be supplied to the printing plate so as to achieve good printing quality could be adjusted to a lower level than with fountain liquid comprising no polyol or glycol ether.

EXAMPLE 3

Several printing plates were prepared identically as described in Example 1. The printing procedure with each of the resulting printing plates was as follows.

The dry printing plate was placed on a HEIDELBERG T-Offset (TOK) press and moistened with a fountain liquid as specified hereinafter. The ink used was a commercially available KAST + EHINGER NOVAVIT 12002 red ink.

When the fountain liquid having the following composition was used:

| | |
|---|---|
| primary sodium phosphate dihydrate | 6 g |
| secondary sodium phosphate dodecahydrate | 1 g |
| triacetin | 20 ml |
| diethylene glycol | 50 ml |
| water to make | 1000 ml |

phosphoric acid to adjust the pH of the solution to 5.5

the prints obtained with the damper set at position 1 were entirely free of fog and showed an excellent quality.

## Claims

1. Method for lithographic printing by means of a lithographic printing plate, which has been prepared from a photolithographic sheet element according to the silver complex diffusion transfer reversal process and carries an oleophilic silver image on its surface, said method comprising moistening said lithographic printing plate with a fountain liquid, supplying ink to the moistened printing plate, and printing, characterized in that said fountain liquid comprises triacetin in an amount of about 0.1 to about 30 percent by volume.

2. A method according to claim 1, characterized in that said fountain liquid comprises triacetin in an amount of about 0.8 to about 5 percent by volume.

3. A method according to claim 1 or 2, characterized in that said fountain liquid comprises phosphoric acid and or acid phosphate salts.

4. A method according to claim 3, characterized in that said fountain liquid comprises a primary sodium or ammonium phosphate and/or a secondary sodium or ammonium phosphate.

5. A method according to any of the claims 1 to 4, characterized in that said fountain liquid comprises a polyol and/or a glycol ether, which is (are) completely soluble in water.

6. A fountain liquid characterized in that it comprises triacetin in an amount of about 0.1 to about 30 percent by volume.

7. A fountain liquid according to claim 6, characterized in that it comprises triacetin in an amount of about 0.8 to about 5 percent by volume.

## DOCUMENTS CONSIDERED TO BE RELEVANT

| Category | Citation of document with indication, where appropriate, of relevant passages | Relevant to claim | CLASSIFICATION OF THE APPLICATION (Int Cl 4) |
|---|---|---|---|
| X | US-A-3 666 502 (G.L. ERIKSON) * Column 2, lines 34-47; column 6, line 63 - column 7, line 2; column 7, lines 47-51 * | 1-7 | B 41 N 3/08<br>G 03 F 7/06 |
| | ----- | | |

TECHNICAL FIELDS
SEARCHED (Int Cl 4)

B 41 N
G 03 F

The present search report has been drawn up for all claims

| Place of search | Date of completion of the search | Examiner |
|---|---|---|
| THE HAGUE | 03-06-1986 | AMAND J.R.P. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO Form 1503 03 82